# EUROPEAN PATENT APPLICATION

(11) **EP 3 916 819 A1**
(43) Date of publication of application: **01.12.2021**
(21) Application number: 20177541.8
(22) Date of filing: 29.05.2020
(51) Int. Cl.: H01L 51/00, C09D 11/52, H01L 51/42

(54) **PEROVSKITE LAYER**

(71) Applicant: Nederlandse Organisatie voor toegepast- natuurwetenschappelijk Onderzoek TNO, 2595 DA 's-Gravenhage (NL)
(72) Inventor: VAN BREEMEN,Albert Jos Jan marie, 2595 DA 's-Gravenhage (NL); GELINCK, Gerwin Hermanus, 2595 DA 's-Gravenhage (NL)
(74) Representative: V.O.

(57) **Abstract**

The invention is in the field of semiconductors. The invention is directed to a composition, a method for producing a layer, a layer, a Photoconducting device and a photovoltaic device.

The composition of the invention comprises
- a matrix comprising a polymer, and
- dispersed in said matrix one or more perovskite materials.

## Description

The invention is in the field of semiconductors. The invention is directed to a composition, a method for producing a layer, a layer, a photoconducting device and a photovoltaic device.

Semiconductors are used in a wide variety of electronic and optoelectronic devices. A class of semiconductor materials that are used extensively in optoelectronics applications, in which photons are converted into an electronic signal or vice versa, are perovskites. Perovskite materials, *i.e.,* materials that exhibit the perovskite lattice structure with general formula ABX₃, in which A and B are cations of different size and X is an anion, are applied in optoelectronic devices such as photovoltaic cells and X-ray and/or γ-ray detectors. For these applications, is important that the perovskite materials exhibit, depending on the application, specific electronic or optoelectronic properties, for instance a specific bandgap, high charge carrier mobility and long charge carrier lifetime, and a high signal to noise ratio. Typically, these properties are best achieved using a single crystal of a perovskite material. However, producing single crystals of perovskite materials is a slow process, often involving precarious wet chemical procedures. Therefore, the production of single crystals leads to high production costs. In addition, for some applications, it may be required that thick layers of perovskite material covering a large area are produced, and it can be very challenging to produce single crystals with the desired dimensions.

In the art, several alternatives to single crystal perovskites are known. In Kim et al., Nature 2017, 550, 87-91, a metal halide perovskite layer is made by spreading out a precursor solution into a film, after which a metal halide perovskite material is formed *in situ* in the precursor solution film. However, perovskite formation is generally difficult to control, especially *in situ* in such a precursor solution film. Therefore, it is difficult to obtain good quality layers using this method.

Another alternative to a single crystal is a layer of perovskite material produced by sintering of perovskite particles. Such a method is described in Shrestha et al., Nature Photonics 2017, 11, 436-440. Methods involving sintering also have a number of disadvantages. First of all, these methods requires a good distribution of powder over a large area prior to sintering, which is difficult to achieve. Furthermore, the sintering typically results in a layer that exhibits poor adhesion to substrates, such as electrodes.

Furthermore, metal halide perovskite materials made using these alternative methods have inferior electronic or optoelectronic properties compared to single crystals. Typically, the carrier mobility-lifetime (µτ) product, which can be used as a measure for the quality of a semiconductor material, of materials obtained using these alternative methods is a factor 100 lower than for single crystals.

An object of the invention is to provide a perovskite material that is easier and/or less expensive to produce than the methods known in the art, especially when thick layers and/or layers covering a large area are required. Compared to the known alternatives to a single crystal, the perovskite material according to the invention has comparable or better electronic properties, such as charge carrier mobility and charge carrier lifetime. Another object of the invention is to address one or more of the disadvantages of the materials and methods know in the art.

To this end, in a first aspect of the invention, there is provided a composition comprising
- a matrix comprising a polymer, and
- dispersed in said matrix one or more perovskite materials
   wherein
- the one or more perovskite materials comprise one or more metal halide perovskite materials, and/or
- the composition comprises the one or more perovskite materials in an amount of more than 50 percent by weight of the total composition.

According to a second aspect of the invention, there is provided a method for producing a layer comprising a composition as described herein.

According to a third aspect of the invention, there is provided a layer comprising a composition as described herein.

According to a fourth and fifth aspect, provided are a photoconducting device and a photovoltaic device comprising a composition and/or a layer as described herein.

Surprisingly, it was found that compositions comprising perovskite materials dispersed in a matrix comprising a polymer show favourable optoelectronic properties, such as high charge transport, *i.e.,* high carrier mobility (µ) and long carrier lifetime (τ), as well as low dark current and high sensitivity in detection of high-energy radiation, such as X-rays. Traditionally, it is believed that a semiconductor material for electronic or optoelectronic applications should have very little defects or grain boundaries in order to exhibit acceptable electronic properties, such as high charge transport. Therefore, the methods for production of semiconductor materials for optoelectronic applications known in the art are typically aimed at achieving a material in which the amount of defects or grain boundaries are minimized. It is surprising that the composition of the present invention, which inherently comprises a large number of grain boundaries, exhibits good optoelectronic properties. Additionally, the composition of the present invention, as well as layers comprising this composition and devices comprising such a composition and/or layer can be prepared with less effort and at lower costs than the methods known in the art.

In accordance with the invention, there is provided a composition comprising
- a matrix comprising a polymer, and
- dispersed in said matrix one or more perovskite materials
wherein
- the one or more perovskite materials comprise one or more metal halide perovskite materials, and/or
- the composition comprises the one or more perovskite materials in an amount of more than 50 percent by weight of the total composition.

The one or more perovskite materials may be present as solid particles, preferably with an average particle size of 0.01-75 µm, more preferably 0.5-50 µm, such as 1-20 µm. For example, the average particle size may be 2-15 µm, 3-10 µm, 4-20 µm or 5-20 µm. In case the particles are too small, such as smaller than 0.5 µm or smaller than 0.1 µm, the (opto-)electronic properties of the composition may be negatively affected. If the particles are too large, for instance larger than 75 µm or larger than 100 µm, the surface of a layer made of the composition may become rough and/or irregular, which is undesirable.

The solid particles in the composition may be a mixture of particles of different sizes. In that case, the solid particles preferably have a narrow size distribution. As used herein, a narrow size distribution means a standard deviation of less than 50 %, preferably less than 40 %, more preferably less than 20 %, such as less than 10 % of the average particle size. In some embodiments, the standard deviation is less than 15 % of the average particle size of the solid particles.

The particle size and particle size distribution can for instance be measured using scanning electron microscopy (SEM) or optical microscopy. Another method to determine particle sizes, or to obtain particles within a desired size range is sieving. By using sieves with an appropriate mesh size, it can be determined whether particles fall within the desired range, or particles with the desired size range can be selected from a mixture of particles with a larger range of particle sizes than the desired particle size range.

The composition is not limited to specific combinations of perovskite materials and polymers. The matrix may comprise one type of polymer, or more than one type of polymer. The polymer or polymers may be selected from a wide range of different materials.

Preferably, the polymer or polymers are transparent for the type of electromagnetic radiation for which a device in which the composition may be applied is used. For instance, if the composition is to be used for the conversion of X-rays, the matrix and the polymers therein are preferably transparent to X-rays.

In embodiments, the polymer or polymers are selected from rubbers and/or elastomeric polymers, because this may positively affect the mechanical properties of the composition. For instance, a composition comprising a polymer of polymers selected from rubbers and/or elastomeric polymers may be less prone to cracking compared to a composition that does not comprise a polymer of polymers selected from rubbers and/or elastomeric polymers.

The matrix may comprise insulating, conducting, and/or semiconducting polymers. Surprisingly, good electronic properties of the composition were also observed when the matrix comprised insulating polymers.

The polymer or polymers may for instance be selected from sodium o-sulfobenzaldehyde acetal of poly(vinyl alcohol); chloro-sulfonated poly(ethylene); a mixture of macromolecular bisphenol poly(carbonates) and copolymers comprising bisphenol carbonates and poly(alkylene oxides); aqueous ethanol soluble nylons; poly(alkyl acrylates and methacrylates); copolymers of poly(alkyl acrylates and methacrylates with acrylic and methacrylic acid); poly(vinyl butyral); poly(urethane) elastomers; and mixtures thereof.

In embodiments, the polymer or polymers are selected from organic polymers such as cellulose acetate butyrate, polyalkyl (meth)acrylates, polyvinyl-n-butyral, poly(vinylacetate-co-vinylchloride), poly(acrylonitrile-co-butadiene-co-styrene), poly(vinyl chloride-co-vinyl acetate-co-vinylalcohol), poly(butyl acrylate), poly(ethyl acrylate), poly(methacrylic acid), poly(vinyl butyral), trimellitic acid, butenedioic anhydride, phtalic anhydride, polyisoprene, and/or mixtures thereof.

Preferably, the polymer or polymers are selected from styrenic block copolymers, for instance styrene-hydrogenated diene block copolymers, having a saturated rubber block from polybutadiene or polyisoprene. Particularly suitable thermoplastic rubbers, which can be used as block-copolymeric polymers in the composition according to the invention are the polymers sold under the trade name Kraton™, such as Kraton™ G rubbers. Good results were obtained using Kraton™ FG1901, a linear triblock copolymer based on styrene and ethylene/butylene with a polystyrene content of 30 %.

The polymer or polymers may also be selected from semiconducting or conducting polymers known in the field and being used in e.g. organic light emitting diodes (OLEDs), organic thin film transistors (OTFTs), and organic photovoltaics (OPV). Examples of such polymers are polyfluorenes, polyphenylenes, polypyrenes, polyazulenes, polynaphthalenes, polypyrroles (PPy), polycarbazoles, polyindoles, polyazepines, polyanilines, polythiophenes, poly(alkylthiophene)s, poly(3,4-ethylenedioxythiophene) (PEDOT), poly(p-phenylene sulfide) (PPS), polyacetylenes (PAc), poly(p-phenylene vinylene) (PPV), polycarbazoles, diketopyrrolopyrrole (DPP)-based polymers, poly(naphthalene diimide) polymers and poly(triarylamine)s such as poly[bis(4-phenyl)(2,4,6-trimethylphenyl)amine]. These polymers can be homopolymers, consisting of one type of repeating units, e.g. aromatic conjugated units, but also copolymers, block copolymers, terpolymers, *etc.* in which more than one repeating units are incorporated, for instance more than one type of conjugated units, or a combination of a conjugated unit with a non-conjugated unit.

As used herein, the term perovskites materials refers to materials that exhibit the perovskite structure. Generally, perovskites materials have the general formula ABX₃, wherein A and B are cations of different size and X is an anion, although perovskite materials with other formulas also exist, as described below. Perovskite materials include oxides in which X represents an O²⁻-anion, such as strontium titanate, calcium titanate, lead titanate, bismuth ferrite, lanthanum ytterbium oxide, lanthanum manganite, among others. Metal halide perovskite materials, in which X represents a halide anion such as F⁻, Cl⁻, Br⁻, I⁻, or a mixture thereof, are another type of perovskite materials.

The electronic and optoelectronic properties of perovskite materials are dependent on their chemical structure. Preferably, the one or more perovskite materials are selected from metal halide perovskite materials, because metal halide perovskite materials have (opto-)electronic properties that make them especially suitable for use in various applications, such as the detection of high-energy radiation and photovoltaics.

The one or more perovskite materials can be selected from organo-metallic perovskites, purely inorganic perovskites, or mixtures thereof. With regard to the general formula of perovskite materials ABX₃, A may for instance be CH₃NH₃⁺ (methylammonium), CH₃CH₂NH₃⁺ (ethylammonium), CH₃CH₂CH₂NH₃⁺ (propylammonium), etc. A may for instance also represent HC(NH₂)₂⁺ (formamidinium), Cs⁺, or Rb⁺. B may for instance represent Pb²⁺, Sn²⁺ Cu²⁺, Ni²⁺, Bi²⁺, Co²⁺, Fe²⁺, Mn²⁺, Cr²⁺, Cd²⁺, Ge²⁺, Yb²⁺, or mixtures thereof. X may selected from Cl⁻, Br⁻, I⁻, and mixtures thereof. For example, the one or more perovskite materials can be selected from organo-metallic metal halide perovskite materials such as CH₃NH₃PbI₃, CH₃NH₃PbBr₃, HC(NH₂)₂PbI₃, CH₃NH₃PbICl₂, HC(NH₂)₂PbBr₃, CH₃CH₂NH₃PbI₃, CH₃CH₂CH₂NH₃PbI₃, CH₃CH₂NH₃PbBr₃, and CH₃CH₂CH₂NH₃PbBr₃. Examples of inorganic metal halide perovskite materials include CsPbX₃ and CsSnX₃, wherein X represents Cl⁻, Br⁻, I⁻, or a mixture thereof, for instance CsPbBr₃. The one or more perovskite materials may also be selected from materials which have the formula A₂BX₄, such as (CH₃CH₂CH₂CH₂NH₃)₂PbI₄, (C₆H₅CH₂NH₃)₂PbI₄, and (C₆H₅CH₂CH₂NH₃)₂PbI₄. The one or more perovskite materials may also be selected from materials which have the formula A₂MM'X₆, wherein M may be Cu⁺, and/or Ag⁺, M' may be Bi³⁺, Ga³⁺, Sb³⁺, and/or In³⁺, for instance Cs₂AgBiBr₆. The one or more perovskite materials may also have the formula A₃M'₂X₉, for instance Cs₃Sb₂Br₉, Rb₃Bi₂Br₉, Rb₃Sb₂Br₉.

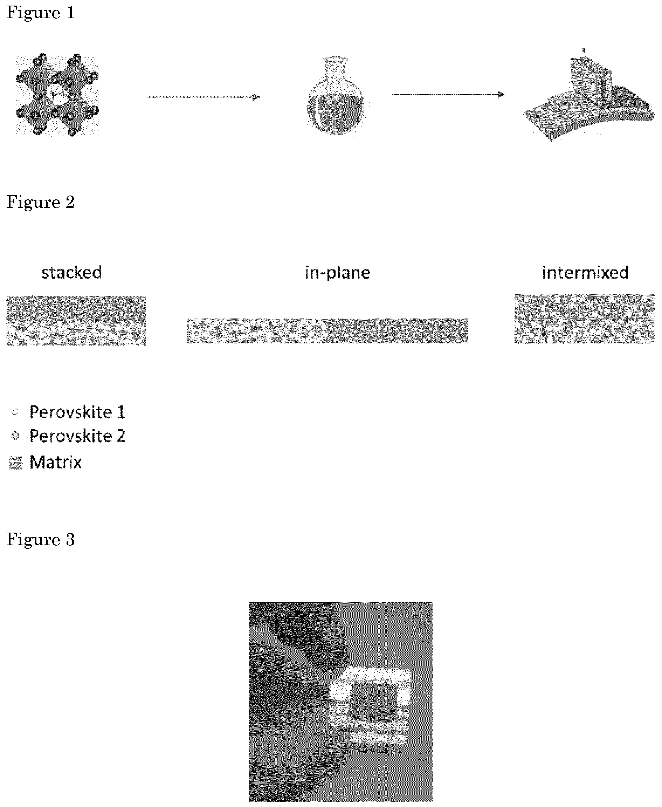

Possible combinations of more than one perovskite materials include layers comprising different perovskite materials on top of each other, layers comprising different perovskite materials next to each other in-plane, or layers comprising different perovskite materials with different properties, e.g. with a different bandgap, intermixed. In this way, the electronic or optoelectronic properties of the composition can be tuned and adjusted for the desired application. A schematic overview of different ways for combining more than one perovskite materials is shown in figure 2.

The composition preferably comprises more than 50 % by total weight of the composition of the one or more perovskite materials. If the amount of the one or more perovskite materials is lower than this, the electronic properties of the composition may be negatively affected. Preferably, the composition comprises 60 % or more by total weight of the composition of the one or more perovskite materials, more preferably 70 % or more by total weight of the composition. The amount of the one or more perovskite materials in the composition may be as high as 99.5 % by total weight of the composition. If the amount of perovskite in the composition is too high, it may complicate the process of producing the composition and/or layers of the composition. For instance, the composition may comprise 80-98 % by total weight of the composition of the one or more perovskite materials, or 90-99 %, or 95-99 %.

The composition preferably comprises 50 % or less by total weight of the composition of the matrix comprising a polymer. Preferably, the composition comprises 40 % or less by total weight of the composition of the matrix comprising a polymer, more preferably 30 % or less. The amount of the matrix comprising a polymer in the composition may be as low as 0.5 % by total weight of the composition. If the amount of matrix comprising a polymer in the composition is too low, it may complicate the process of producing layers of the composition. For instance, the composition may comprise 0.5-30 % by total weight of the composition of the matrix comprising a polymer, or 1-25 %, or 1-10 %, or even 0.5-5 %.

The product of charge carrier mobility (µ) and charge carrier lifetime (τ) is known as the µτ product, which is dependent on the applied electrical field. It is desirable to achieve a high µτ product, while applying a low electrical field. Applying a too high electrical field may for instance negatively influence the stability of the composition. The µτ product of the composition of the invention may be 5 × 10⁻⁵ cm²V⁻¹ or higher, preferably 1 × 10⁻⁴ cm²V⁻¹ or higher, more preferably 2.5 × 10⁻⁴ cm²V⁻¹ or higher, even more preferably 5 × 10⁻⁴ cm²V⁻¹ or higher. such as 1 × 10⁻³ cm²V⁻¹ or higher. The µτ product that can be achieved for compositions according to the invention may be as high as 5 × 10⁻³ cm²V⁻¹, but will typically be lower.

The above-mentioned µτ products may be achieved using an electrical field of 2 V/µm or less, preferably 1 V/µm or less, more preferably 0.5 V/µm or less, even more preferably 0.2 V/µm or less, such as 0.1 V/µm or less. The above-mentioned µτ products may be achieved using an electrical field of as low as 0.05 V/µm, but the applied electrical field will typically be higher.

The composition and/or matrix may further comprise additional compounds such as adhesive agents, plasticizers, photocurable monomers, photoinitiators, antistatic agents, surfactants and/or stabilizers.

There is also provided a method for producing a layer comprising a composition as described herein comprising the steps of:
- dispersing one or more perovskite materials in a fluid, thereby creating a dispersion,
- coating a substrate with the dispersion;
wherein the fluid comprises:
- a polymer,
- a curable compound, and/or
- a solvent in which the one or more perovskite materials are not soluble.

In embodiments, the fluid comprises a solvent in which the one or more perovskite materials are not soluble. A solvent can be applied for instance in order to dissolve polymers, curable compounds, and/or other constituents of the fluid, especially if these constituents are not a fluid at the conditions at which the coating step takes place. The solvent can also be used to adjust the viscosity of the dispersion, such that the dispersion can be applied to a substrate more easily. Suitable solvents in which the one or more perovskite materials are not soluble include non-polar solvents, such as for instance toluene, xylene and hexane.

Alternatively or additionally, it is also possible to apply other approaches to ensure that the constituents of the fluid are indeed fluid during the coating step, and/or to adjust the viscosity of the dispersion, for instance by heating or cooling the dispersion.

In embodiments, the method of the invention further comprises a step of curing the dispersion. In case a solvent is present in the fluid, the curing step may have the function of evaporating the solvent. If the curing step is a heat treatment in order to evaporate the solvent, the curing step may also referred to as annealing. Alternatively or additionally, the curing step may be applied in order to facilitate polymerisation and/or crosslinking in the dispersion. The curing step may comprise treatment with vacuum, electromagnetic radiation and/or heat. Preferable, the curing step comprises treatment with radiation, such as ultraviolet radiation.

The fluid and/or dispersion may further comprise additional compounds such as curable (*e.g.* photocurable) monomers, curable (*e.g.* photocurable) oligomers, photoinitiators, adhesive agents, plasticizers, antistatic agents, surfactants and/or stabilizers. These additional compounds may serve more than one purpose. For instance, curable monomers or oligomers may be used to optimize the viscosity of the dispersion such that the coating step can be performed well. Additionally, the same curable monomers or oligomers can also provide the composition and/or the matrix with the desired mechanical properties after curing, *i.e.,* after polymerisation and/or crosslinking.

The coating step may comprise blade coating, screen printing, stencil printing, and/or additive manufacturing. Additive manufacturing is also known as 3D-printing. Suitable additive manufacturing techniques include stereolithography (SLA) and fused filament fabrication (FFF). These techniques can advantageously be used in order to produce a patterned layer, *i.e.,* a layer that is selectively applied on parts of a substrate, according to a predetermined pattern, which is useful for the production of electronic and/or optoelectronic devices. Using these techniques, it is also possible to apply layers comprising different perovskite materials next to each other in-plane and/or on top of each other, as illustrated in figure 2.

The method as described herein may further comprise a step wherein the layer is compacted using heat and/or mechanical force.

Optionally, layers that are produced using the method of the invention are passivated. Passivation may be achieved by coating the layer with a passivating coating, for instance using atomic layer deposition (ALD), in order to passivate defects. Such a passivation coating may be used to improve the electronic or optoelectronic properties of the layer. In embodiments, the passivating coating comprises aluminium oxide.

An advantage of using a dispersion of one or more perovskite materials in a fluid for producing a layer, as opposed to producing a layer by coating a substrate with a precursor for a perovskite material, is that the perovskite material can be produced under conditions that can be controlled much better, compared to the conditions in the precursor layer. This results in much better control over the properties of the perovskite material, such as crystallite size and size distribution. Furthermore, additional steps, such as purification of the perovskite material can be applied before dispersing the material in a fluid, which is more convenient compared to applying such additional steps in a layer in which the metal halide perovskite is formed from a precursor solution *in situ.*

In figure 1, a schematic representation of a method according to an embodiment of the invention is shown. First of all, a perovskite material is provided, optionally purified and/or altered. This material is dispersed in a fluid, thereby creating a dispersion, and subsequently, a substrate is coated with the dispersion.

According to invention, there is also provided a layer comprising a composition as described herein.

Preferably, the layer is obtainable by the method as described herein.

The layer comprising a composition as described herein can have a wide range of thicknesses. Depending on the application and coating technique, the layer thickness may in the range of micrometres to millimetres. Preferably, the layer has a thickness of 10 µm or more, preferably 50 µm or more, more preferably 100 µm or more, such as 200 µm or more. The layer may be thick as 10 millimetres, but will generally be less than 5 mm. For instance, the layer has a thickness of 50-5000 µm, preferably 150-2000 µm, or 300-1000 µm.

The fluid in which the one or more perovskite materials are dispersed may in some cases have the same chemical composition as the matrix of the resulting composition. However, the fluid used in the method and the matrix of the resulting composition may also have a different chemical composition. Possible differences in chemical composition between the fluid and the matrix are influenced by various factors, such as the used coating technique, whether or not a curing and/or compacting step have been applied, and the nature of such a curing and/or compacting step. For example, if the fluid in which the one or more perovskite materials are dispersed comprises a solvent, and if this solvent is evaporated in an optional curing step, the chemical composition of the fluid differs from the chemical composition of the matrix. Alternatively, if the used coating technique and optional curing, compacting, and/or any other additional steps do not induce changes in the chemical composition of the fluid, e.g. by evaporation or reaction of one or more of the constituents of the fluid, the chemical composition of the matrix may be the same as the chemical composition of the fluid.

Using the method according to the invention, it is also possible to apply multiple layers on top of each other. These layers may have the same composition, or a different composition. When different layers have a different composition, they may differ in the type of polymer in the matrix, in the type of the one more perovskite materials, and/or in the relative amounts of the matrix and/or the one more perovskite materials.

In case two or more layers according to the invention are applied on top of each other, it is possible to cure a previously applied layer before applying a subsequent layer on top of the previously applied layer. This can be done for instance in order to prevent constituents of the matrix of the previously applied layer to dissolve in the fluid of the subsequent layer. Especially if layers with a different composition are to be applied on top of each other, curing a previously applied layer before applying the next layer may prevent mixing of those layers. Another approach for preventing mixing of subsequent layers may be to use a different solvent in the subsequent layer that is not able to dissolve constituents of the matrix of the previously applied layer. Conversely, in cases where mixing between subsequent layers is desired, a first layer can also be deliberately left uncured before applying a subsequent layer.

The composition and/or layer as described herein may be applied in a wide range of optoelectronic devices. The composition and/or layer may for instance be applied in a photoconducting device, such as a direct conversion X-ray or γ-ray detector. Alternatively, the composition and/or layer may be used in photovoltaic devices, such as solar cells. The properties of the composition and or layer can be optimized depending on the application. For instance, the bandgap of the one or perovskite materials can be selected in order to fit the desired application. Alternatively or additionally, the bandgap of the one or more perovskite materials may be tuned using dopants. Other factors, such as the composition of the matrix or the relative amounts of matrix and perovskite material can also be optimized, depending on the application.

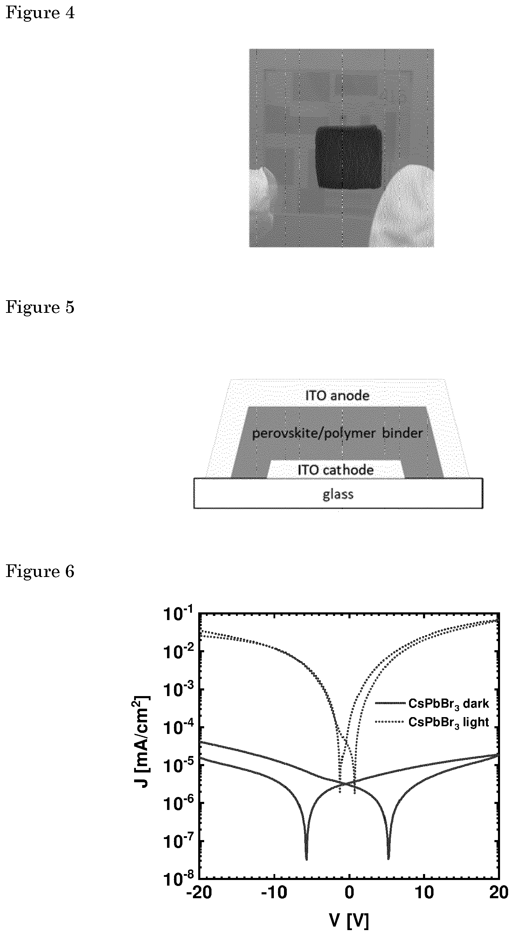

Optoelectronic devices typically comprise one or more layers of a semiconductor material. Depending on their properties and depending on the intended application of the device, one or more layers according to the invention may act for instance as a photoconducting material, as a photovoltaic material, and/or as an carrier-selective layer. Layers according to the invention can also be brought in contact with one or more electrodes. In addition, other layers can be present, for instance between a layer according to the invention and an electrode, in order to optimize the electronic and/or optoelectronic properties of the device. Figure 5 shows an example of how a layer according to an embodiment of the invention is in contact with an indium tin oxide anode as well as an indium tin oxide cathode.

In an embodiment, a layer according to the invention is used to improve the mechanical robustness of a high-energy radiation detector (such as an X-ray detector) by extending the layer, or parts thereof, beyond the active area of the detector. When layers according to the invention are applied on a substrate, the mechanical properties of the substrate can be improved, especially when the applied layer is relatively thick compared to the thickness of the substrate. Because the layer according to the invention can be applied relatively easily, it can be advantageous to apply the layer on a larger area than would be necessary for its electronic function, in order to improve the mechanical robustness and/or handleability of parts comprising a layer according to invention, such as an X-ray detector.

### Examples

### Example 1 - Preparation of a layer of perovskite dispersed in a matrix.

0.5 g Kraton™ FG1901 (Kraton Polymers Research RV) and 7.5 ml toluene (Sigma Aldrich, 99.8 %) were mixed in a planetary centrifugal mixer (Thinky Mixer USA) at 3000 rpm for 15 minutes. To 0.7 g of the resulting clear, transparent and viscous solution, 2.46 g perovskite powder was added and mixed at 3000 rpm for 15 minutes in a planetary centrifugal mixer (Thinky Mixer USA). The dispersion was deposited on a glass substrate with pre-patterned indium tin oxide (ITO) bottom electrode using doctor blade coating through a 0.5 mm thick metal stencil. Subsequently the wet layer was annealed on a hot plate at 80 °C for 20 minutes to obtain a dry layer of *ca.* 300 µm thickness. Finally, a patterned ITO top electrode was sputtered on the perovskite layer.

Figure 3 is a photograph of a layer of CsPbBr₃ dispersed in a matrix comprising Kraton™ FG1901, applied onto a substrate, produced according example 1.

Figure 4 is a photograph of a layer of methylammonium lead iodide (CH₃NH₃PbI₃) dispersed in a matrix comprising Kraton™ FG1901, applied onto a substrate, produced according example 1.

### Example 2 - Preparation of a layer of perovskite dispersed in a matrix.

0.5 g Kraton™ FG1901 (Kraton Polymers Research RV) and 7.5 ml xylene (Sigma Aldrich, 99.8 %) were mixed in a planetary centrifugal mixer (Thinky Mixer USA) at 3000 rpm for 15 minutes. To 0.7 g of the resulting clear, transparent and viscous solution, 2.46 g perovskite powder was added and mixed at 3000 rpm for 15 minutes in a planetary centrifugal mixer (Thinky Mixer USA). On a glass substrate with pre-patterned indium tin oxide (ITO) bottom electrode, a tin oxide electron transport layer was deposited by means of spincoating a colloidal dispersion and subsequent annealing at 140 °C. The perovskite dispersion was deposited on said substrate using doctor blade coating through a 0.5 mm thick metal stencil. Subsequently the wet layer was annealed in a vacuum oven at 110 °C for 30 minutes to obtain a dry layer of *ca.* 300 µm thickness. A molybdenum oxide hole transport layer was deposited using vapour deposition, followed by a patterned ITO top electrode.

### Example 2 - Comparison with other metal halide perovskite layers.

The current densities of the layers obtained in example 1 were compared to other alternatives to a perovskite single crystal.

Figure 6 shows the JV sweep of a 300 µm thick layer of CsPbBr₃ dispersed in a matrix comprising Kraton™ FG1901 sandwiched between two indium tin oxide electrodes, measured in dark and light conditions. Device area was 1 mm². A dark current density of 10⁻⁵ mA cm⁻² at +/- 20 V can be derived.

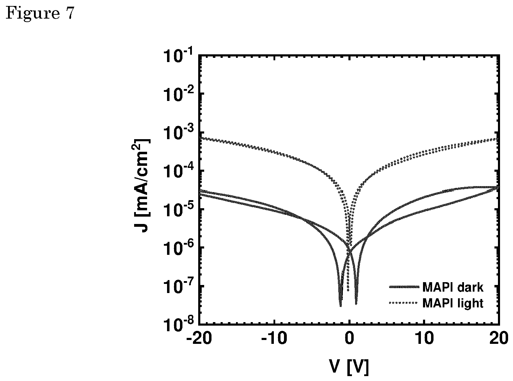

Figure 7 shows the JV sweep of a 300 µm thick layer of CH₃NH₃PbI₃ dispersed in a matrix comprising Kraton™ FG1901 sandwiched between two indium tin oxide electrodes, measured in dark and light conditions. Device area was 1 mm². A dark current density of 3 × 10⁻⁵ mA cm⁻² at a bias of +/- 20V (electrical field +/- 0.07 V/µm) can be derived.

In comparison, Kim et al., (Nature 2017, 550, 87-91) have reported a dark current density of a printed CH₃NH₃PbI₃ layer sandwiched between two ITO electrodes of 3 × 10⁻² mA cm⁻² at a bias of 55 V (electrical field of 0.07 V/µm). Using an optimized device stack Kim *et al.* reduced the dark current density to 1 × 10⁻⁴ mA cm⁻² at the same bias. Shresta et al. (Nature Photonics 2017, 11, 436-440) have reported a dark current density of a sintered CH₃NH₃PbI₃ device of 6 × 10⁻³ mA cm⁻² at an electrical field of 0.2 V/µm, and using an optimized device stack in which the electric contacts of the 1-mm-thick CH₃NH₃PbI₃ wafer are formed by poly(3,4-ethylenedioxythiophene) polystyrene sulfonate (PEDOT:PSS) and phenyl-C61-butyric acid methyl ester (PCBM) and ZnO as hole-selective and electron-selective contact and buffer layers, respectively. A bottom ITO/glass substrate and a silver top electrode finish the device stack.

## Claims

1. Composition comprising
- a matrix comprising a polymer, and
- dispersed in said matrix one or more perovskite materials,
wherein
- the one or more perovskite materials comprise one or more metal halide perovskite materials, and/or
- the composition comprises the one or more perovskite materials in an amount of more than 50 percent by weight of the total composition.

2. Composition according to claim 1, wherein the one or more perovskite materials are present as solid particles, preferably with an average particle size of 0.01-75 µm, more preferably 0.5-50 µm, such as 1-20 µm.

3. Composition according to claim 1 or 2, wherein the polymer comprises one or more selected from the group consisting of insulating polymers, semiconducting polymers, and conducting polymers.

4. Composition according to any one of claims 1-3, wherein the polymer comprises one or more selected from the group consisting of styrenic block copolymers, and polyamines such as poly(triarylamine)s, preferably the polymer is a linear triblock copolymer based on styrene and ethylene/butylene.

5. Composition according to any one of claims 1-4, wherein the one or more perovskite materials are selected from organo-metallic metal halide perovskite materials such as methylammonium lead iodide (CH₃NH₃PbI₃).

6. Composition according to any one of claims 1-4, wherein the one or more perovskite materials are selected from inorganic metal halide perovskite materials such as CsPbBr₃.

7. Method for producing a layer comprising a composition according to any one of claims 1-6, comprising the steps of:
- dispersing one or more perovskite materials in a fluid, thereby creating a dispersion,
- coating a substrate with the dispersion;
wherein the fluid comprises:
- a polymer,
- a curable compound, and/or
- a solvent in which the one or more perovskite materials are not soluble.

8. Method according to claim 7, further comprising a step of curing the dispersion.

9. Method according to claim 7 or 8, wherein the coating step comprises blade coating, screen printing, stencil printing, and/or additive manufacturing.

10. Method according to any one of claims 7-9, further comprising a step wherein the layer is compacted using heat and/or mechanical force.

11. Layer comprising a composition according to any one of claims 1-6, wherein said layer is preferably obtainable by a method according to any one of claims 7-10.

12. Layer according to claim 11, having a thickness of 100 µm or more, preferably 100-1000 µm.

13. Photoconducting device comprising a composition according to any one of claims 1-6 and/or a layer according to claim 11 or 12.

14. Photovoltaic device comprising a composition according to any one of claims 1-6 and/or a layer according to claim 11 or 12.

15. Photoconducting device according to claim 13 or photovoltaic device according to claim 14, comprising two or more different perovskite materials as defined in claim 1, wherein
a) said two or more different perovskite materials are each present in a separate layer according to claim 11, and wherein said layers are stacked on top of each other,
b) said two or more different perovskite materials are each present in a separate sections of an in-plane layer, or
c) said two or more different perovskite materials are present and intermixed in the same layer.
